# FASCICULE DE BREVET EUROPEEN

(11) **EP 3 214 660 B1**
(45) Date de publication et mention de la délivrance du brevet: **11.08.2021**
(21) Numéro de dépôt: 17158489.9
(22) Date de dépôt: 28.02.2017
(51) Int. Cl.: H01L 31/12, H01L 33/08, H01L 33/24, B60Q 1/08, B60Q 1/22, B60Q 1/26, B60Q 1/38, F21S 43/145, F21S 43/16

(54) **SOURCE DE LUMIERE A SEMI-CONDUCTEURS ET SYSTEME D'AIDE A LA CONDUITE POUR VEHICULE AUTOMOBILE COMPORTANT UNE TELLE SOURCE**
LICHTQUELLE MIT HALBLEITERN, UND FAHRASSISTENZSYSTEM FÜR KRAFTFAHRZEUG, DAS EINE SOLCHE LICHTQUELLE UMFASST
SEMICONDUCTOR LIGHT SOURCE AND DRIVER ASSISTANCE SYSTEM FOR MOTOR VEHICLE COMPRISING SUCH A SOURCE

(30) Priorité: 02.03.2016 FR 1651752
(43) Date de publication de la demande: 06.09.2017
(73) Titulaire: Valeo Vision, 93012 Bobigny Cedex (FR)
(72) Inventeur: ALBOU, Pierre, 75013 PARIS (FR); REISS, Benoit, 95580 MAGENCY (FR)

(56) Documents cités:
- EP-A1- 2 819 326
- WO-A1-2010/014032
- DE-A1-102013 104 273
- US-A1- 2012 223 289
- US-A1- 2013 190 971
- US-A1- 2014 166 974

## Description

La présente invention concerne de manière générale les systèmes d'aide à la conduite utilisant des sources de lumière.

Certains systèmes d'assistance utilisent une caméra embarquée à l'arrière du véhicule pour aider le conducteur dans ses manœuvres de recul. On voit également des caméras apparaître en remplacement ou complément des rétroviseurs. Elles seront bientôt une aide pour la détection de l'environnement dans le cadre des véhicules autonomes.

En usage nocturne, il est nécessaire d'éclairer la zone d'observation de la caméra. Lors d'une manœuvre de recul, c'est généralement l'allumage du feu de recul qui permet d'éclairer la zone sur la route à proximité du véhicule. L'éclairage est néanmoins de faible portée et il n'est pas possible d'augmenter la portée d'un feu de recul sans risquer de ne plus être en conformité avec les contraintes de signalisation.

Les documents DE 10 2013 104273 A1, US 2014/166974 A1, US 2012/223289 A1, et WO 2010/014032 A1 divulguent des sources de lumière selon l'art antérieur. Le document US 2013/190971 A1 divulgue un système d'aide à la conduite pour véhicule automobile selon l'art antérieur.

Un aspect de l'invention a pour objet une source de lumière à semi-conducteur selon la revendication 1.

Selon une variante ne faisant pas partie de l'invention revendiquée, la première longueur d'onde et la deuxième longueur d'onde sont choisies dans le spectre visible ;
Selon d'autres caractéristiques avantageuses :
- la source de lumière peut comporter en outre un troisième ensemble de bâtonnets électroluminescents reliés électriquement entre eux, ledit troisième ensemble étant dédié à une réception d'un faisceau lumineux à une troisième longueur d'onde ;
- la troisième longueur d'onde est choisie de sorte que le troisième ensemble forme une zone de réception apte à recevoir des faisceaux lumineux à ladite première longueur d'onde ;
- les bâtonnets électroluminescents sont de préférence sur un même substrat ;
- les bâtonnets du premier ensemble et les bâtonnets du deuxième ensemble sont répartis de préférence de sorte que le premier ensemble et le deuxième ensemble forment deux zones imbriquées ;
- lesdits bâtonnets sont par exemple séparés deux à deux d'une distance inférieure ou égale à 30 microns.

La présente invention a également pour objet un système d'aide à la conduite pour véhicule automobile selon la revendication 7.

Le dispositif de réception est formé par exemple par une caméra ;
Ladite au moins une source de lumière peut aussi comporter un troisième ensemble de bâtonnets électroluminescents reliés électriquement entre eux, ledit troisième ensemble formant ledit dispositif de réception ;
Ladite au moins une source de lumière est placée avantageusement dans un dispositif d'éclairage et/ou de signalisation d'un véhicule automobile, et le système comporte en outre un dispositif de commande apte à activer indépendamment les deux zones d'émission, en simultané et/ou en alternance ;
La deuxième longueur d'onde est choisie pour émettre une lumière de couleur ambre, ou une lumière de couleur rouge, ou une lumière de couleur blanche ;
- ladite au moins une source peut comporter un luminophore sur au moins une zone en regard des bâtonnets du premier ensemble et/ou du deuxième ensemble.

L'invention et ses avantages seront mieux compris au vu de la description qui suit, faite en référence aux figures annexées, dans lesquelles :
- la figure 1 illustre schématiquement le principe d'une source de lumière à semi-conducteur et bâtonnets de dimensions submillimétriques, avec une vue en perspective dans laquelle on a rendu visible en coupe une rangée de bâtonnets électroluminescents ;
- la figure 2 représente, en vue schématique de côté et de dessus, un premier exemple d'une source lumineuse à semi-conducteur et bâtonnets de dimensions submillimétriques conforme à la présente invention ;
- la figure 3 représente, en vue schématique de côté et de dessus, un autre exemple d'une source lumineuse à semi-conducteur et bâtonnets de dimensions submillimétriques conforme à la présente invention ;
- la figure 4 représente, en vue schématique de côté et de dessus, un autre exemple d'une source lumineuse à semi-conducteur et bâtonnets de dimensions submillimétriques conforme à la présente invention ;
- les figures 5a à 5d illustrent schématiquement d'autres dispositions possibles.

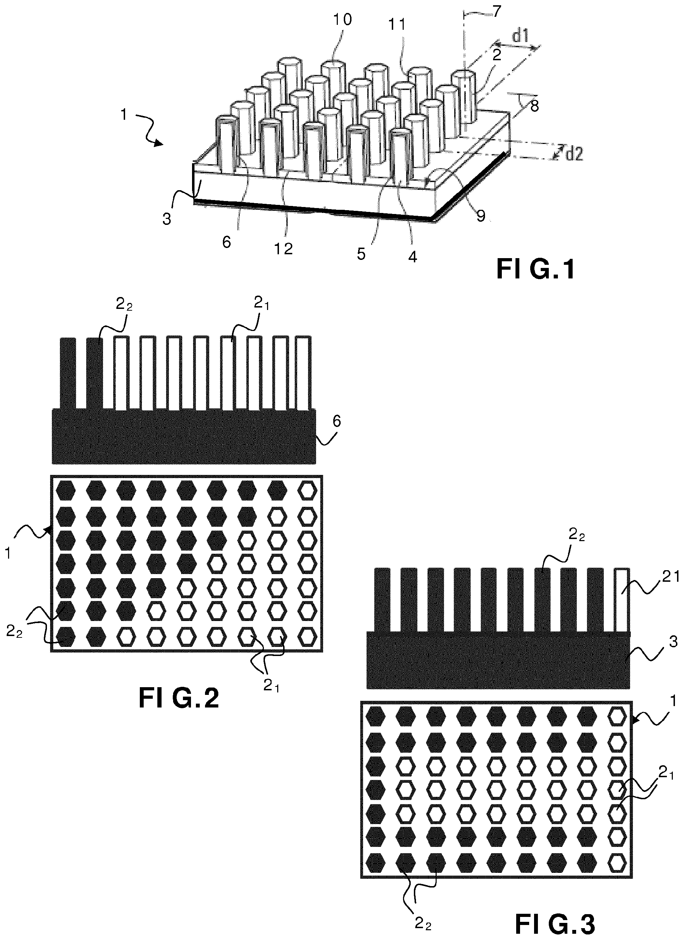

Une source conforme à l'invention est une source de lumière à semi-conducteur comprenant une pluralité de bâtonnets électroluminescents de dimensions submillimétriques, dans laquelle au moins certains bâtonnets sont connectés électriquement entre eux en un premier ensemble dédié à une émission d'un faisceau lumineux à une première longueur d'onde, et d'autres bâtonnets sont connectés électriquement entre eux en un deuxième ensemble dédié à une émission d'un faisceau lumineux à une deuxième longueur d'onde différente de la première longueur d'onde, le premier ensemble et le deuxième ensemble formant deux zones d'émission activables sélectivement. Des exemples de configurations d'ensembles seront décrits à partir de la figure 2.

Dans le contexte de l'invention, un ensemble de bâtonnets émettant à une certaine longueur d'onde d'émission ne s'entend pas comme un ensemble de bâtonnets émettant strictement à une seule longueur d'onde comme une diode laser mais à l'intérieur d'un certain intervalle de longueur d'onde qui est de l'ordre de 10 nm.

On va dans un premier temps décrire la structure d'une source de lumière 1 à semi- conducteurs comportant des bâtonnets électroluminescents de dimensions submillimétriques en se référant notamment à la figure 2, laquelle figure ne montre pas les ensembles précités.

En référence à la figure 1, une source de lumière sur laquelle repose l'invention est une source 1 à semi-conducteur, comprenant une pluralité de bâtonnets électroluminescents 2 de dimensions submillimétriques, que l'on appellera par la suite bâtonnets électroluminescents, c'est-à-dire des sources à semi-conducteur en trois dimensions tel que cela sera exposé ci-après, contrairement aux sources classiques en deux dimensions, présentant des couches émissives sensiblement planes, alors qu'une source à bâtonnets électroluminescents présente des couches émissives sous la forme de reliefs en saillie.

Ces bâtonnets électroluminescents 2 prennent naissance de préférence sur un même substrat 3. Chaque bâtonnet électroluminescent, ici formé par utilisation de nitrure de gallium (GaN), s'étend perpendiculairement, ou sensiblement perpendiculairement, en saillie du substrat 3, ici réalisé à base de silicium, d'autres matériaux comme du carbure de silicium pouvant être utilisés pour le substrat sans sortir du contexte de l'invention.

Les bâtonnets électroluminescents sont par exemple réalisés à partir d'un composé à base de nitrure d'aluminium et de gallium (AIGaN) notamment pour de émettre de l'ultraviolet. Il s'agira encore par exemple d'arséniure de galium (AsGa) pour l'infrarouge ou d'un phosphore d'aluminium, d'indium et de Gallium (AlInGaP) pour du rouge.

Les bâtonnets électroluminescents 2 de dimensions submillimétriques s'étirent depuis le substrat 3 et comportent chacun un noyau 4 en nitrure de gallium, autour duquel sont disposés des puits quantiques 5 formés par une superposition radiale de couches de matériaux différents, par exemple du nitrure de gallium et du nitrure de gallium-indium, et une coque 6 entourant les puits quantiques également réalisée en nitrure de gallium.

Chaque bâtonnet s'étend selon un axe longitudinal 7 définissant sa hauteur, la base de chaque bâtonnet étant disposée dans un plan 8 de la face supérieure 9 du substrat 3.

Les bâtonnets électroluminescents 2 de la source de lumière à semi-conducteur peuvent présenter la même forme. Ces bâtonnets sont chacun délimités par une face terminale 10 et par une paroi circonférentielle 11 qui s'étend le long de l'axe longitudinal 7. Lorsque les bâtonnets électroluminescents 2 sont dopés et font l'objet d'une polarisation, la lumière résultante en sortie de la source à semi-conducteur est émise principalement à partir de la paroi circonférentielle 11, étant entendu que l'on peut prévoir que des rayons lumineux sortent également, au moins en petite quantité, à partir de la face terminale 10. Il en résulte que chaque bâtonnet 2 agit comme une unique diode électroluminescente et que la densité des bâtonnets électroluminescents améliore le rendement de cette source à semi-conducteur.

Différentes couches de matériaux sont superposées sur la face supérieure 9 du substrat, notamment après la croissance des bâtonnets électroluminescents depuis le substrat ici obtenue par une approche ascendante. Parmi ces différentes couches, on peut trouver au moins une couche de matériau conducteur électriquement, afin de permettre l'alimentation électrique des bâtonnets. Cette couche est gravée de manière à relier tel ou tel bâtonnet entre eux, l'allumage de ces bâtonnets pouvant alors être commandé simultanément par un module de commande ici non représenté.

La paroi circonférentielle 11 d'un bâtonnet 2, correspondant à la coquille de nitrure de gallium, est recouverte par une couche d'oxyde conducteur transparent (TCO) 12 qui forme l'anode de chaque bâtonnet complémentaire à la cathode formée par le substrat 3. Cette paroi circonférentielle 11 s'étend le long de l'axe longitudinal 7 depuis le substrat 3 jusqu'à la face terminale 10, la distance de la face terminale 10 à la face supérieure 9 du substrat, depuis laquelle prennent naissance les bâtonnets électroluminescents 2, définissant la hauteur de chaque bâtonnet. A titre d'exemple, on prévoit que la hauteur d'un bâtonnet électroluminescent 2 est comprise entre 1 et 10 micromètres, tandis que l'on prévoit que la plus grande dimension transversale de la face terminale, perpendiculairement à l'axe longitudinal 7 du bâtonnet électroluminescent concerné, soit inférieure à 2 micromètres. On pourra également prévoir de définir la surface d'un bâtonnet, dans un plan de coupe perpendiculaire à cet axe longitudinal 7, dans une plage de valeurs déterminées, et notamment entre 1 et 5 micromètres carré.

Ces dimensions, données à titre d'exemple non limitatif, permettent de démarquer une source de lumière à semi-conducteur comprenant des bâtonnets électroluminescents d'une source de lumière des sources à diodes sensiblement planes.

On comprend que lors de la formation des bâtonnets 2, la hauteur peut être modifiée d'une source de lumière à l'autre, de manière à accroitre la luminance de la source de lumière à semi-conducteur lorsque la hauteur est augmentée. La hauteur des bâtonnets peut également être modifiée au sein d'une unique source de lumière, de sorte qu'un groupe de bâtonnets peut avoir une hauteur, ou des hauteurs, différentes d'un autre groupe de bâtonnets.

La forme des bâtonnets électroluminescents 2 peut également varier d'un dispositif à l'autre, notamment sur la section des bâtonnets et sur la forme de la face terminale 10. Il a été illustré sur la figure 1 des bâtonnets électroluminescents présentant une forme générale cylindrique, et notamment de section polygonale, ici plus particulièrement hexagonale. On comprend qu'il importe que de la lumière puisse être émise à travers la paroi circonférentielle, que celle-ci présente une forme polygonale ou circulaire par exemple.

Par ailleurs, la face terminale 10 peut présenter une forme sensiblement plane et perpendiculaire à la paroi circonférentielle, de sorte qu'elle s'étend sensiblement parallèlement à la face supérieure 9 du substrat 3, tel que cela est illustré sur la figure 1, ou bien elle peut présenter une forme bombée ou en pointe en son centre, de manière à multiplier les directions d'émission de la lumière sortant de cette face terminale.

Sur la figure 1, les bâtonnets électroluminescents 2 sont agencés en matrice à deux dimensions. Cet agencement pourrait être tel que les bâtonnets électroluminescents soient agencés en quinconce. L'invention couvre d'autres répartitions des bâtonnets, avec notamment des densités de bâtonnets qui peuvent être variables d'une source de lumière à l'autre, et qui peuvent être variables selon différentes zones d'une même source de lumière. On a représenté sur la figure 1 la distance de séparation d1 de deux bâtonnets électroluminescents immédiatement adjacents dans une première direction transversale et la distance de séparation d2 de deux bâtonnets électroluminescents immédiatement adjacents dans une deuxième direction transversale. Les distances de séparation d1 et d2 sont mesurées entre deux axes longitudinaux 7 de bâtonnets électroluminescents adjacents. Le nombre de bâtonnets électroluminescents 2 s'étendant en saillie du substrat 7 peut varier d'un dispositif à l'autre, notamment pour augmenter la densité lumineuse de la source de lumière, mais on convient que l'une et l'autre des distances de séparation d1, d2 sont de préférence inférieures ou égales à 30 micromètres, par exemple inférieures ou égales 10 micromètres.

La source de lumière peut comporter en outre, une couche (non représentée) d'un matériau polymère dans laquelle des bâtonnets électroluminescents 2 sont au moins partiellement noyés. La couche peut ainsi s'étendre sur toute l'étendue du substrat ou seulement autour d'un groupe déterminé de bâtonnets électroluminescents. Le matériau polymère, qui peut notamment être à base de silicone, permet de protéger les bâtonnets électroluminescents sans gêner la diffusion des rayons lumineux. En outre, il est possible d'intégrer dans cette couche de matériau polymère des moyens de conversion de longueur d'onde, et par exemple des luminophores, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation.

La source de lumière 1 comporte ici une forme rectangulaire, mais on comprendra qu'il peut présenter sans sortir du contexte de l'invention d'autres formes générales, et notamment une forme de parallélogramme.

Selon l'invention, et comme plus particulièrement visible sur les exemples de configurations donnés à partir de la figure 2, au moins certains bâtonnets 2, référencés 2₁ sur les figures, sont connectés électriquement entre eux en un premier ensemble dédié à une émission d'un faisceau lumineux à une première longueur d'onde, et d'autres bâtonnets 2₂ sont connectés électriquement entre eux en un deuxième ensemble dédié à une émission d'un faisceau lumineux à une deuxième longueur d'onde différente de la première longueur d'onde, le premier et le deuxième ensembles formant deux zones d'émission activables sélectivement.

Dans le cas de la figure 2, les deux ensembles sont juxtaposés, en ce sens qu'ils ne se chevauchent pas.

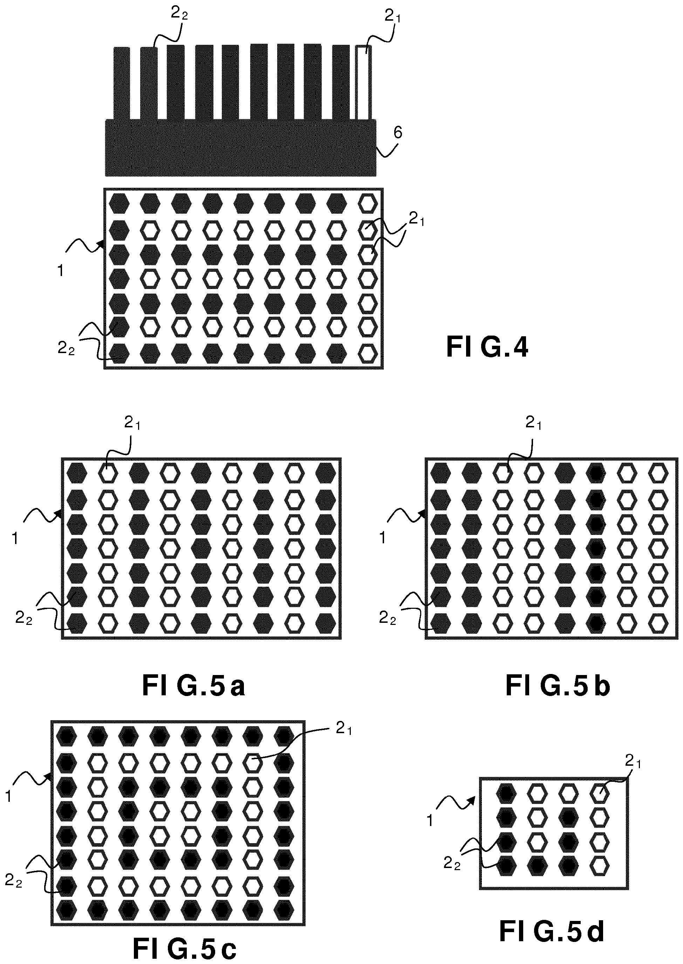

Dans le cas des figures 3 et 4, les bâtonnets 2₁ du premier ensemble et les bâtonnets 2₂ du deuxième ensemble sont agencés de sorte que le premier ensemble et le deuxième ensemble forment deux ensembles imbriqués.

Les ensembles peuvent notamment être imbriqués de façon à ce que les barycentres géométriques respectifs du motif de leurs bâtonnets soient proches l'un de l'autre, typiquement d'une distance inférieure à 100 micromètres.

D'autres motifs pour les ensembles peuvent être adoptés, sans départir du cadre de la présente invention, à partir du moment où la source dispose bien d'un ensemble dédié à l'émission d'un premier faisceau lumineux, et d'un ensemble dédié à l'émission d'un deuxième faisceau lumineux. Ainsi, on a représenté sur les graphes de la figure 5 des exemples d'autres dispositions des ensembles de bâtonnets électroluminescents 2₁, 2₂. Les figures 5a et 5b représentent des dispositions régulières, en bandes successives. Chaque bande forme une sous-zone, soit du premier ensemble de bâtonnets 2₁, soit du deuxième ensemble de bâtonnets 2₂, et une sous-zone du premier ensemble est entourée de sous-zones du deuxième ensemble.

Les bâtonnets électroluminescents 2₁ sont tous raccordés électriquement ensemble avec des ponts de connexion électrique. Il en va de même pour les bâtonnets électroluminescents 2₂. Ainsi, lorsqu'un ensemble de bâtonnets est activé, tous les bâtonnets le composant, qu'ils soient ou non entourés par des bâtonnets participant à l'autre ensemble, est alimenté au même courant électrique. L'intensité lumineuse émise par la zone correspondant au premier ensemble peut être avantageusement différente de celle de la zone correspondant au deuxième ensemble, et si la surface couverte par les première et deuxième zones sont identiques, comme cela est le cas dans l'illustration des figures 5a et 5b, on pourra faire varier cette intensité d'une zone à l'autre en jouant sur l'intensité du courant d'alimentation, ce qui est rendu possible par le fait que ces deux zones sont raccordées électriquement distinctement l'une de l'autre, ou bien en jouant sur la densité/et ou la hauteur des bâtonnets dans chacune des zones et sous-zones.

Sur la figure 5c, les zones émettrices correspondant au premier et au deuxième ensemble n'ont pas la même taille et elles ne présentent pas le même nombre de bâtonnets électroluminescents 2₁, 2₂ de dimensions submillimétriques. Chaque zone est composée de sous-zones disposées les unes autour des autres de sorte qu'une sous-zone du premier ensemble est entourée par une sous-zone du deuxième ensemble, et qu'au moins une sous-zone du deuxième ensemble 6 est entourée par une sous-zone du premier ensemble. Dans le cas illustré, les strates successives présentent la forme de carrés disposés les uns autour des autres, mais on pourrait prévoir que les bâtonnets soient agencées en sous-zones sensiblement circulaires agencées concentriquement sur le centre de la source de lumière. Là encore, un pont de connexion électrique est à prévoir entre chaque sous-zone d'un même ensemble de bâtonnets.

Tel qu'illustré sur la figure 5d, l'enchevêtrement des zones des deux ensembles peut être réalisée par des formes intrusives de sous-zones de bâtonnets 2₁ à l'intérieur d'une étendue propre à une autre zone de bâtonnets 2₂, mais avec des bâtonnets d'une même zone raccordés de proche en proche, sans qu'il soit dès lors nécessaire de prévoir un pont de raccordement électrique entre des sous-zones séparées l'une de l'autre. Une telle disposition facilite le raccordement électrique de l'ensemble.

Un système d'aide à la conduite pour véhicule automobile conforme à l'invention associe la source de lumière 1 précédemment décrite à un dispositif de réception apte à recevoir des faisceaux lumineux à la première longueur d'onde, par exemple une caméra embarquée à l'arrière du véhicule.

La source de lumière est avantageusement logée dans un boîtier fermé par une glace d'un dispositif d'éclairage et/ou de signalisation d'un véhicule automobile. Le boîtier définit un volume interne de réception de cette source de lumière associée à une optique de mise en forme adaptée pour imager à l'infini au moins une partie des rayons lumineux émis par la source de lumière, lors des activations simultanées ou non des bâtonnets des deux ensembles.

Au moins un des rayons émis par la source de lumière est dévié par l'optique de mise en forme. On entend par dévié que la direction d'entrée du rayon lumineux dans l'optique de mise en forme est différente de la direction de sortie du rayon lumineux de l'optique de mise en forme. L'optique de mise en forme comprend au moins un élément optique tel qu'une ou plusieurs lentilles, un ou plusieurs réflecteurs, un ou plusieurs guides de lumière ou une combinaison de ces possibilités. L'optique de mise en forme peut comprendre une optique de projection de la lumière émise par la source de lumière à semi-conducteur. Cette optique de projection crée une image réelle, et éventuellement anamorphosée, d'une partie du dispositif, par exemple la source elle-même ou un cache, ou d'une image intermédiaire de la source, à distance (finie ou infinie) très grande devant les dimensions du dispositif (d'un rapport de l'ordre d'au moins 30, de préférence 100) du dispositif. Cette optique de projection peut consister en un ou plusieurs réflecteurs, ou bien en une ou plusieurs lentilles, ou un ou plusieurs guides de lumière ou encore en une combinaison de ces possibilités.

La configuration particulière de la source permet d'utiliser un même système optique associé à la zone d'émission de chacun des ensembles.

Le système comporte en outre un dispositif de commande apte à activer indépendamment les deux ensembles d'émission, en simultané et/ou en alternance, selon les applications recherchées.

Le choix de la deuxième longueur d'onde dépend de la fonction d'éclairage et/ou de signalisation que l'on souhaite réaliser. Ainsi, la deuxième longueur d'onde sera choisie pour émettre une lumière de couleur ambre dans le cas d'un indicateur de direction, de couleur rouge pour un feu stop, ou de couleur blanche pour un feu de recul.

Selon une variante ne faisant pas partie de l'invention, la première longueur d'onde pourra quant à elle être choisie dans le spectre visible, et selon l'invention la première longueur d'onde est choisie dans l'infrarouge ou l'ultra-violet. Dans ce dernier cas, les deux ensembles seront par exemple activés simultanément.

## Revendications

1. Source (1) de lumière à semi-conducteur comprenant une pluralité de sources à semi-conducteur en trois dimensions de dimensions submillimétriques, dans laquelle au moins certaines sources à semi-conducteur en trois dimensions sont connectées électriquement entre elles en un premier ensemble dédié à une émission d'un faisceau lumineux à une première longueur d'onde, et d'autres sources à semi-conducteur en trois dimensions sont connectées électriquement entre elles en un deuxième ensemble dédié à une émission d'un faisceau lumineux à une deuxième longueur d'onde différente de la première longueur d'onde, le premier et le deuxième ensembles formant deux zones d'émission activables sélectivement, et la deuxième longueur d'onde étant choisie dans le spectre visible, **caractérisée en ce que** la première longueur d'onde est choisie dans l'infrarouge ou l'ultraviolet.

2. Source de lumière selon la revendication 1, comportant en outre un troisième ensemble de sources à semi-conducteur en trois dimensions reliées électriquement entre elles, ledit troisième ensemble étant dédié à une réception d'un faisceau lumineux à une troisième longueur d'onde.

3. Source de lumière selon la revendication 2, dans laquelle la troisième longueur d'onde est choisie de sorte que le troisième ensemble forme une zone de réception apte à recevoir des faisceaux lumineux à ladite première longueur d'onde.

4. Source de lumière selon l'une quelconque des revendications précédentes, dans laquelle les sources à semi-conducteur en trois dimensions sont sur un même substrat (3).

5. Source de lumière selon la revendication 4, **caractérisée en ce que** les sources à semi-conducteur en trois dimensions du premier ensemble et les sources à semi-conducteur en trois dimensions du deuxième ensemble sont réparties de sorte que le premier ensemble et le deuxième ensemble forment deux zones imbriquées.

6. Source de lumière selon l'une quelconque de revendications précédentes, **caractérisée en ce que** lesdites sources à semi-conducteur en trois dimensions sont séparées deux à deux d'une distance inférieure ou égale à 30 microns.

7. Système d'aide à la conduite pour véhicule automobile, **caractérisé en ce qu'**il comporte au moins une source (1) de lumière à semiconducteurs selon la revendication 1, et un dispositif de réception apte à recevoir des faisceaux lumineux à ladite première longueur d'onde.

8. Système selon la revendication 7, dans lequel le dispositif de réception est formé par une caméra.

9. Système selon la revendication 7, dans lequel ladite au moins une source (1) de lumière comporte en outre un troisième ensemble de sources à semi-conducteur en trois dimensions reliées électriquement entre elles, ledit troisième ensemble formant ledit dispositif de réception.

10. Système selon l'une quelconque des revendications 7 à 9, **caractérisé en ce que** ladite au moins une source (1) de lumière est placée dans un dispositif d'éclairage et/ou de signalisation d'un véhicule automobile, et **en ce que** le système comporte en outre un dispositif de commande apte à activer indépendamment les deux zones d'émission, en simultané et/ou en alternance.

11. Système selon la revendication 10, **caractérisé en ce que** la deuxième longueur d'onde est choisie pour émettre une lumière de couleur ambre.

12. Système selon la revendication 10, **caractérisé en ce que** la deuxième longueur d'onde est choisie pour émettre une lumière de couleur rouge.

13. Système selon la revendication 10, **caractérisé en ce que** la deuxième longueur d'onde est choisie pour permettre l'émission d'une lumière de couleur blanche.

14. Système selon l'une quelconque des revendications 7 à 13, **caractérisé en ce que** ladite au moins une source (1) comporte un luminophore sur au moins une zone en regard des sources à semi-conducteur en trois dimensions du premier ensemble et/ou du deuxième ensemble.

## Patentansprüche

1. Halbleiterlichtquelle (1), die eine Vielzahl von dreidimensionalen Halbleiterquellen mit submillimetrischen Abmessungen enthält, wobei mindestens bestimmte dreidimensionale Halbleiterquellen in einer ersten Einheit elektrisch miteinander verbunden sind, die für eine Emission eines Lichtstrahls auf einer ersten Wellenlänge bestimmt ist, und andere dreidimensionale Halbleiterquellen in einer zweiten Einheit elektrisch miteinander verbunden sind, die für eine Emission eines Lichtstrahls auf einer zweiten Wellenlänge anders als die erste Wellenlänge bestimmt ist, wobei die erste und die zweite Einheit zwei selektiv aktivierbare Emissionszonen bilden, und die zweite Wellenlänge im sichtbaren Spektrum gewählt wird, **dadurch gekennzeichnet, dass** die erste Wellenlänge im Infrarotbereich oder im Ultraviolettbereich gewählt wird.

2. Lichtquelle nach Anspruch 1, die außerdem eine dritte Einheit von dreidimensionalen Halbleiterquellen aufweist, die elektrisch miteinander verbunden sind, wobei die dritte Einheit für einen Empfang eines Lichtstrahls auf einer dritten Wellenlänge bestimmt ist.

3. Lichtquelle nach Anspruch 2, wobei die dritte Wellenlänge so gewählt wird, dass die dritte Einheit eine Empfangszone bildet, die Lichtstrahlen auf der ersten Wellenlänge empfangen kann.

4. Lichtquelle nach einem der vorhergehenden Ansprüche, wobei die dreidimensionalen Halbleiterquellen sich auf einem gleichen Substrat (3) befinden.

5. Lichtquelle nach Anspruch 4, **dadurch gekennzeichnet, dass** die dreidimensionalen Halbleiterquellen der ersten Einheit und die dreidimensionalen Halbleiterquellen der zweiten Einheit so verteilt sind, dass die erste Einheit und die zweite Einheit zwei verschachtelte Zonen bilden.

6. Lichtquelle nach einem der vorhergehenden Ansprüche, **dadurch gekennzeichnet, dass** die dreidimensionalen Halbleiterquellen paarweise um einen Abstand von weniger als oder gleich 30 Mikron getrennt sind.

7. Fahrassistenzsystem für ein Kraftfahrzeug, **dadurch gekennzeichnet, dass** es mindestens eine Halbleiterlichtquelle (1) nach Anspruch 1 und eine Empfangsvorrichtung aufweist, die Lichtstrahlen auf der ersten Wellenlänge empfangen kann.

8. System nach Anspruch 7, wobei die Empfangsvorrichtung von einer Kamera gebildet wird.

9. System nach Anspruch 7, wobei die mindestens eine Lichtquelle (1) außerdem eine dritte Einheit von dreidimensionalen Halbleiterquellen aufweist, die elektrisch miteinander verbunden sind, wobei die dritte Einheit die Empfangsvorrichtung bildet.

10. System nach einem der Ansprüche 7 bis 9, **dadurch gekennzeichnet, dass** die mindestens eine Lichtquelle (1) in einer Beleuchtungs- und/oder Signalisierungsvorrichtung eines Kraftfahrzeugs angeordnet ist, und dass das System außerdem eine Steuervorrichtung aufweist, die die zwei Emissionszonen unabhängig gleichzeitig und/oder abwechselnd aktivieren kann.

11. System nach Anspruch 10, **dadurch gekennzeichnet, dass** die zweite Wellenlänge gewählt wird, um ein bernsteinfarbenes Licht zu emittieren.

12. System nach Anspruch 10, **dadurch gekennzeichnet, dass** die zweite Wellenlänge gewählt wird, um ein Licht roter Farbe zu emittieren.

13. System nach Anspruch 10, **dadurch gekennzeichnet, dass** die zweite Wellenlänge gewählt wird, um die Emission eines Lichts weißer Farbe zu erlauben.

14. System nach einem der Ansprüche 7 bis 13, **dadurch gekennzeichnet, dass** die mindestens eine Quelle (1) ein Luminophor auf mindestens einer Zone gegenüber den dreidimensionalen Halbleiterquellen der ersten Einheit und/oder der zweiten Einheit aufweist.

## Claims

1. Semiconductor light source (1) including a plurality of three-dimensional semiconductor sources of submillimetric dimensions, wherein at least certain three-dimensional semiconductor sources are electrically interconnected in a first assembly dedicated to an emission of a light beam at a first wavelength, and other three-dimensional semiconductor sources are electrically interconnected in a second assembly dedicated to an emission of a light beam at a second wavelength different from the first wavelength, the first and the second assemblies forming two selectively activable emission areas, and the second wavelength being selected in the visible spectrum, **characterized in that** the first wavelength is selected in the infrared or the ultraviolet.

2. Light source according to claim 1, further comprising a third assembly of electrically interconnected three-dimensional semiconductor sources, said third assembly being dedicated to receiving a light beam at a third wavelength.

3. Light source according to Claim 2, in which the third wavelength is selected so that the third assembly forms a reception area capable of receiving light beams at said first wavelength.

4. Light source according to any one of the preceding claims, in which the three-dimensional semiconductor sources are on the same substrate (3).

5. Light source according to Claim 4, **characterized in that** the three-dimensional semiconductor sources of the first assembly and the three-dimensional semiconductor sources of the second assembly are distributed so that the first assembly and the second assembly form two areas nested together.

6. Light source according to any one of the preceding claims, **characterized in that** said three-dimensional semiconductor sources are separated two by two by a distance less than or equal to 30 microns.

7. Driving aid system for a motor vehicle, **characterized in that** it comprises at least one semiconductor light source (1) according to claim 1, and a receiving device capable of receiving light beams at said first wavelength.

8. System according to Claim 7, in which the receiving device is formed by a camera.

9. System according to Claim 7, in which said at least one light source (1) further comprises a third assembly of interconnected three-dimensional semiconductor sources, said third assembly forming said receiving device.

10. System according to any one of Claims 7 to 9, **characterized in that** said at least one light source (1) is placed in a lighting and/or signaling device of a motor vehicle, and **in that** the system further comprises a control device capable of independently activating the two emission areas, simultaneously and/or alternately.

11. System according to Claim 10, **characterized in that** the second wavelength is selected for emitting an amber-colored light.

12. System according to Claim 10, **characterized in that** the second wavelength is selected for emitting a red-colored light.

13. System according to Claim 10, **characterized in that** the second wavelength is selected for emitting a white-colored light.

14. System according to any one of Claims 7 to 13, **characterized in that** said at least one source (1) comprises a luminophore on at least one area facing the three-dimensional semiconductor sources of the first assembly and/or of the second assembly.
